# EUROPEAN PATENT SPECIFICATION

(11) **EP 2 216 424 B1**
(45) Date of publication and mention of the grant of the patent: **08.11.2017**
(21) Application number: 10152525.1
(22) Date of filing: 03.02.2010
(51) Int. Cl.: C23C 14/00, C23C 14/35, H01J 37/34

(54) **Techniques for depositing transparent conductive oxide coatings using dual C-MAG sputter apparatuses**
Techniken zum Ablagern von transparenten, leitfähigen Oxidbeschichtungen mittels Dual-C-MAG-Sputtervorrichtungen
Techniques pour le dépôt de revêtements d'oxyde conducteurs transparents à l'aide d'appareils de pulvérisation C-MAG double

(30) Priority: 06.02.2009 US 320904
(43) Date of publication of application: 11.08.2010
(73) Proprietor: Guardian Europe S.à.r.l., 8070 Bertrange (LU); GUARDIAN INDUSTRIES CORP., Auburn Hills, MI 48326-1714 (US)
(72) Inventor: Dietrich, Anton, 9476 Fontnas (CH); Lu, Yiwei, Ann Arbor, MI, 48105 (US); Corsner, Bryce, Seneca Falls, NY, 13148 (US)
(74) Representative: Hess, Peter K. G.

(56) References cited:
- WO-A1-92/01081
- WO-A2-2004/106581
- US-A1- 2002 134 670

## Description

### FIELD OF THE INVENTION

Certain example embodiments of this invention relate to techniques for depositing transparent conductive oxide (TCO) coatings on substrates. More particularly, certain example embodiments of this invention relate to techniques for depositing transparent conductive oxide (TCO) coatings using dual C-MAG sputtering apparatuses. In certain example embodiments, a closed-loop system is created in which (1) about 90% of the oxygen gas provided to the apparatus is provided via a top gas inlet located proximate to the rotating cylindrical tubes of the apparatus and remote from the substrate, (2) pressure within the apparatus is increased to about 10⁻³ to 10⁻² mbar by providing an inert gas flow of at least about 600 sccm, more preferably at least about 700 sccm, and still more preferably at least about 800 sccm, in certain example embodiments, (3) tube rotation is reduced to less than about 5 RPM, more preferably less than about 4 RPM, and still more preferably less than about 3 RPM, and (4) adjusting the power provided to the apparatus in dependence on the presence or absence of oxygen partial pressure oscillations. TCOs such as, for example, ITO, ZnAlOx, SnSbOx, may be deposited according to the techniques of certain example embodiments.

### BACKGROUND AND SUMMARY OF EXAMPLE EMBODIMENTS OF THE INVENTION

The use of sputtering in order to deposit coatings on substrates is known in the art. For example, and without limitation, see U.S. Patent Nos. 5,403,458; 5,317,006; 5,527,439; 5,591,314; 5,262,032; and 5,284,564. Briefly, sputter coating is an electric-discharge-type process which is conducted in a vacuum chamber in the presence of at least one gas. Typically, a sputtering apparatus includes a vacuum chamber, a power source, an anode, and one or more cathode targets which include material used to create a coating on an adjacent substrate (e.g., glass substrate or substrate of other material). The target may include an outer tube enclosing a magnet bar assembly including and an associated inner magnet bar support tube. More specifically, in certain known arrangements, the one or more magnet bars are secured to the underside of the support tube along substantially the entire length of the support tube. In certain example instances, the magnet bar may also include the support tube.

When an electrical potential is applied to the cathode target, the gas forms a plasma that bombards the target, thereby causing particles of the sputtering material from the target to leave the exterior surface of the target. These particles fall onto the substrate to form the coating thereon. The outer target tube typically rotates about the stationary magnets which are supported by the inner support tube so that particles are "sputtered" uniformly from the substantially the entire periphery of the target tube as it rotates past the fixed magnet bar(s).

Co-sputtering of materials is an alternative to complex alloying of metallic materials for a single sputtering target. Dual C-MAG rotatable cylindrical magnetron sputtering apparatuses are known and can accomplish the co-sputtering of materials, e.g., by using two targets placed in relative proximity to one another in the apparatus (e.g., within a common chamber of the sputtering apparatus). The two target tubes may rotate through the plasma, which is confined by the stationary magnet assemblies placed inside of the target tubes. The magnet assemblies, in turn, can be angled or tuned. Two independently operated power supplies may be used in connection with a dual C-MAG apparatus for co-sputtering.

Transparent conductive oxide (TCO) films such as, for example, films comprising indium tin oxide (ITO), ZnAlOx, SnSbOx, and the like, typically are difficult to obtain with reactive sputtering as the film composition, especially the oxygen content, needs to be controlled within a very narrow range around a substantially perfect stoichiometric composition. Common methods to deposit these films are therefore based on ceramic oxide targets, which reduce process instabilities introduced by the oxidation processes taking place at the surface of metallic targets. The disadvantage of ceramic targets are availability for C-MAG's, higher target cost, deposition rate limits (related, in part, to the limited thermal load on these targets) so as to avoid cracking, and reduced target lifetime (related, in part, to the higher effective volume of the compound compared to the pure metal).

Sputter deposition methods using metal targets have been developed to avoid the typical process instability at the process range, which yields the desired film composition. Unfortunately, however, most of these techniques also suffer from certain disadvantages regarding deposition rate and material utilization like using aperture shields (e.g., as known in connection with NiCrOx processes). Additionally, metallic targets were mainly developed for planar sputter targets. See, for example, U.S. Patent No. 4,572842. WO 92/01081 A shows a method for depositing oxide films using dual rotating cylindrical magnetrons. WO2004/106581 A shows a reactive sputtering method for depositing oxide films in which process parameters, eg oxygen partial pressure, are controlled by a feedback loop.

Thus, it will be appreciated that there is a need in the art for improved techniques for depositing TCO films.

Certain example embodiments described herein make use of a special characteristic of the C-MAG targets. Namely, the moving target surface relative to the eroding plasma of C-MAG target surprisingly and unexpectedly allows a dynamic balance between target surface oxidation and oxide removal to be established. Thus, the combination of the example process conditions described herein with a closed-loop control of the erosion/oxidation process based on an oxygen sensor surprisingly and unexpectedly leads to a very stable and controllable process, even for large cathodes as used in industrial glass coaters which, in turn, leads to superior coating techniques in terms of deposition rate and quality as described below.

One aspect of certain example embodiments relates to providing about 90% of the oxygen gas provided to the apparatus via a top gas inlet located proximate to the rotating cylindrical tubes of the apparatus and remote from the substrate.

Another aspect of certain example embodiments relates to increasing the pressure within the apparatus by providing an inert gas flow of at least about 600 sccm, more preferably at least about 700 sccm, and still more preferably at least about 800 sccm. This increases pressure within the apparatus to an advantageous level of about 10⁻³ to 10⁻² mbar.

Another aspect of certain example embodiments relates to reducing tube rotation to less than about 5 RPM, more preferably less than about 4 RPM, and still more preferably less than about 3 RPM.

Still another aspect of certain example embodiments relates to adjusting the power provided to the apparatus in dependence on the presence or absence of oxygen partial pressure oscillations. In certain example embodiments, a medium frequency sine wave power supply operating at about 40kHz alternatively on one of the tubes may be used.

In certain example embodiments of this invention, a magnetron sputtering apparatus for sputter coating an article in a reactive environment comprising oxygen and an inert gas is provided. A vacuum chamber is provided. First and second rotatable cylindrical tubes are located in close relative proximity to one another in the vacuum chamber, with the first and second tubes respectively supporting first and second metallic sputter targets. At least one power source is operably connected to the first and second sputtering tubes. A sensor is configured to detect oxygen flow within the vacuum chamber and/or an amount of power applied to the first and second tubes. A top gas inlet is located proximate to the first and second tubes and on a side of the tubes opposite any article to be coated, with the top gas inlet being configured to receive at least the oxygen flow. A controller is configured to adjust the oxygen flow and/or the amount of power provided by the at least one power source to compensate for oxygen partial pressure variations detected by the sensor. The pressure of the vacuum chamber is increased to about 10-3 to 10-2 mbar by providing a flow of the inert gas. The first and second tubes are configured to rotate at less than about 5 RPM.

In certain example embodiments of this invention, a method of making a coated article is provided. An article to be coated is provided. A sputtering apparatus is provided, with the sputtering apparatus comprising: a vacuum chamber; first and second rotatable cylindrical tubes located in close relative proximity to one another in the vacuum chamber, the first and second tubes respectively supporting first and second sputter targets including target material; at least one power source operably connected to the first and second sputtering tubes; and a top gas inlet located proximate to the first and second tubes and on a side of the tubes opposite the article to be coated. An oxygen flow is provided to the vacuum chamber through the top gas inlet. An inert gas flow is provided to the vacuum chamber to increase pressure therein to about 10-3 to 10-2 mbar. The first and second tubes are rotated at less than about 5 RPM. The oxygen flow within the vacuum chamber and/or an amount of power applied to the first and second tubes is/are detected. The oxygen flow and/or amount of power provided by the at least one power source is/are adjusted to compensate for any detected oxygen partial pressure variations. A coating is deposited on the article to be coated in making the coated article.

In certain example embodiments of this invention, a method of making a coated article using a dual C-MAG sputtering apparatus is provided. An article to be coated is provided. A reactive environment is created within the sputtering apparatus, with the reactive environment comprising oxygen and argon gasses, the argon gas being provided at a flow rate sufficient to increase pressure within the reactive environment to about 10-3 to 10-2 mbar. First and second tubes of the sputtering apparatus are rotated at less than about 5 RPM. Oxygen flow within the reactive environment and/or an amount of power applied to a cathode of the sputtering apparatus is/are detected. The oxygen flow and/or amount of power is/are adjusted to compensate for any detected oxygen partial pressure variations. A coating is deposited on the article to be coated in making the coated article.

The features, aspects, advantages, and example embodiments described herein may be combined to realize yet further embodiments.

### BRIEF DESCRIPTION OF THE DRAWINGS

These and other features and advantages will be better and more completely understood by reference to the following detailed description of exemplary illustrative embodiments in conjunction with the drawings, of which:
Figure 1 is a simplified and partially schematic side elevation of a sputtering apparatus;
Figure 2 shows a side cross-section of a magnet bar structure in accordance with an example embodiment;
Figure 3 shows the settings used for the single layer sample of ITO produced in accordance with an example embodiment;
Figure 4 compares the data taken for 600 sccm Ar and 800 sccm Ar flow at otherwise constant process conditions (e.g., power and gas distribution);
Figure 5 shows the transition chart obtained for 800 sccm Ar, with the rate of change in the Lambda signal included;
Figures 6a and 6b show the thickness and resistivity profiles for the low and high pressure samples produced in accordance with the techniques of certain example embodiments;
Figures 7a-f show a series of thickness and resistivity profiles for the varying Lambda control set points for certain example embodiments;
Figure 8 shows the deviation from uniform distribution that was returned for all samples;
Figures 9a-b show the correlation between thickness uniformity and absorption;
Figures 10a-c represent different ways to visualize the example trim gas flows used during the tuning of the single layers;
Figures 11a-h summarize the moves in trim gas settings to obtain a reasonably flat thickness and resistance profile for certain example embodiments;
Figure 12 summarizes the trim gas moves discussed above and shows the relative deviation of oxygen flow from a flat distribution;
Figures 13a-b show the overall pressure variation across the coat bay for certain example embodiments;
Figure 14 shows the cross-ribbon thickness variation of ITO thin films fabricated under the control of the Lambda sensor controller at two different modes in accordance with an example embodiment; and
Figure 15 is a table that includes properties of the ITO thin films fabricated under different control modes.

### DETAILED DESCRIPTION OF EXAMPLE EMBODIMENTS OF THE INVENTION

In certain example embodiments of this invention, techniques are provided for depositing transparent conductive oxide (TCO) coatings using dual C-MAG sputtering apparatuses. A closed-loop system is provided in certain example embodiments. In this closed-loop system of certain example embodiments, (1) about 90% of the oxygen gas provided to the apparatus is provided via a top gas inlet located proximate to the rotating cylindrical tubes of the apparatus and remote from the substrate, (2) pressure within the apparatus is increased by providing an inert gas flow of at least about 600 sccm, more preferably at least about 700 sccm, and still more preferably at least about 800 sccm, (3) tube rotation is reduced to less than about 5 RPM, more preferably less than about 4 RPM, and still more preferably less than about 3 RPM, and (4) adjusting the power provided to the apparatus in dependence on the presence or absence of oxygen partial pressure oscillations. TCOs such as, for example, ITO, ZnAlOx, SnSbOx, may be deposited according to the techniques of certain example embodiments.

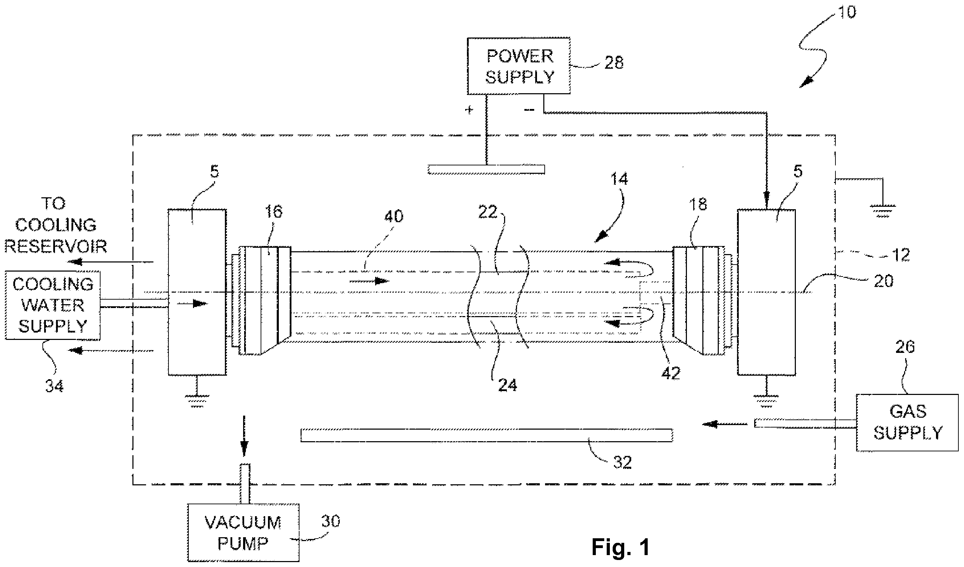

Referring now more particularly to the accompanying drawings in which like reference numerals indicate like parts throughout the several views, Fig. 1 illustrates, in simplified form, a magnetron sputtering apparatus 10. The apparatus includes metal walls 12 of the vacuum chamber in which sputtering is performed; a cylindrical rotating target/tube 14 that is supported at opposite ends by a bearing block 16 and a drive block 18 so that the target is rotatable about axis 20; and an inner stationary magnet bar support tube 22 that supports a magnet carrier and an associated magnet (represented by block 24) that extends along the underside of the inner support tube 22, substantially the entire length of both the inner support tube and the outer target tube. Gas is supplied to the vacuum tube via an external gas supply 26 while power is supplied via external power supply 28. The chamber is evacuated by a vacuum pump 30.

In a typical sputtering process, the plasma formed when an electrical potential is applied to the cathode target bombards the target and the dislodged particles of sputtering material from the target fall onto the substrate 32 to be coated, forming a coating thereon. Throughout the process, the target tube may be cooled to a specified temperature; e.g., cooling water from a source 34 may be introduced into the interior of the hollow inner support tube 22 at one end thereof through the bearing block 16, and may exit the opposite end of the tube through a plurality of nozzle or jet apertures provided in an end plate. The apertures may be arranged to emit streams parallel to the longitudinal axis of the target tube and/or at an acute angle thereto. The cooling water then reverses direction and flows back along the exterior of the inner tube 22, in the chamber or space 40 radially between the inner support tube 22 and the outer rotating target tube 14, exiting the target tube via the same bearing block 16. Note that while the support tube 22 is terminated short of the drive block 18 to permit the cooling fluid to exit the tube and reverse flow through the chamber 40, an inner spindle 42 that may be fixed to the end plate, supports the inner tube in the drive block 18.

In conventional arrangements, an example material that may be used in the tube (other than the magnets themselves) is a nonmagnetic stainless steel alloy.

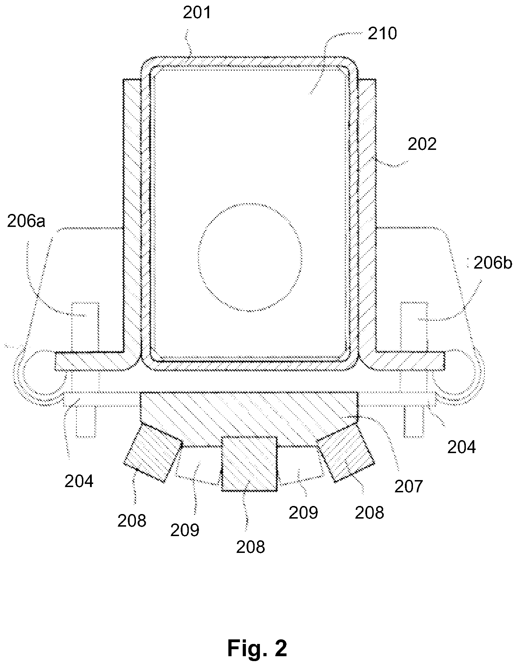

Fig. 2 shows a cross-section of a magnetic bar structure in accordance with an example embodiment. The magnet bar structure of Fig. 2 may be used in connection with a rotating magnetron sputtering apparatus as shown in Fig. 1, where the sputtering tube/target with the sputtering material thereon rotates around the stationary magnet structure.

In Fig. 2, an elongated main mounting part (static profile or support) 202 is mounted on elongated hollow tube 201 and is connected to a magnet carrier support 204 and a magnet carrier or magnet carrier module 207. The hollow portion of tube 201 is indicated at 210. Mounting part 202 may be made up of one or multiple parts in different embodiments, but may include two spaced apart members as shown in Fig. 2 that are provided on opposite sides of tube 201. Magnet carrier 207 is elongated in shape and supports one or more elongated magnet segments 208. Each magnet bar is made up of a plurality of elongated magnet segments 208 arranged in a substantially linear manner, or in series. In other words, a magnet bar may be said to be a row of substantially aligned magnet portions. Immediately adjacent ones of the linearly arranged magnet segments 208 of a given magnet bar may be spaced apart from one another, or alternatively may abut one another, in different example embodiments.

In addition to supporting the magnet segment(s) 208 of the respective magnet bars, the magnet carrier 207 also may optionally support end magnets 209. End magnets 209 are located at one or both ends of the carrier 207, and thus at one or both ends of the bars which are made up of the magnet segments 208. In certain embodiments, a plurality of magnet carrier supports 204 are provided in series on each side of the carrier 207 along the length of the target, with one or more magnet segments 208 being mounted for adjustment via each carrier support 204. Generally, the mounting part 202 extends in a continuous manner along substantially the entire length of each side of tube 201. One or more magnet carriers 207 may be provided along the length of the tube 201 so as to be aligned in series, which each carrier 207 optionally being selectively adjustable with respect to position thereby permitting the position of the magnet segment(s) 208 mounted thereon to be selectively adjusted along with that of 207. In certain example instances, the magnet bar portion of the system may also include the support tube.

Thus, it will be appreciated that there may be provided a rotatable magnetron sputtering target comprising a rotatable target tube (see 14 in Fig. 1) comprising sputtering material on an outer surface thereof to be sputter deposited on a substrate (e.g., onto a glass substrate or the like), a magnet bar structure provided within the rotatable target tube 14, wherein the magnet bar structure is stationary when the rotatable tube 14 is rotating during sputtering, and wherein the magnet bar structure comprises at least one elongated magnet bar which includes a plurality of different magnet segments 208 that are aligned in a substantially linear manner along at least a substantial portion of the magnet bar structure.

In certain example embodiments, the connection between mounting part 202 and magnet carrier support 204 is made using screws 206a-b. However, it will be appreciated that other methods or techniques of attaching mounting part 202 to magnet carrier support 204 may instead be used. It also will be appreciated that mounting part 202 and magnet carrier support 204 may be fixedly attached to each other, although this arrangement might potentially limit the degree to which the magnetic elements 208 can be tuned/adjusted.

According to certain embodiments, turning one of screws 206a-b adjusts the distance between the corresponding magnet segment 208 which is located closest to the screw and tube 201; and optionally turning the other screw which is also located adjacent the segment 208 but across the tube 201 may fix the adjustment. In such an example embodiment, it will be appreciated that the handedness may be reversed such that, for example, screw 206a may be used for adjusting the height and screw 206b may be used for fixing the height, or vice versa. It also will be appreciated that more than two screws may be used to fix each magnetic carrier support 204 to mounting part 202. By adjusting the position of magnet carrier support 204 relative to mounting part 202 using one of the screws, the height/position of magnet bar segment(s) 208 mounted on that particular support 204 will also be adjusted in a desirable manner thereby permitting one to easily adjust the positions of magnet segments and thus adjust the magnetic field to be used during sputtering. Using such an arrangement, the magnetic field may be adjusted for substantial uniformity, at least in terms of the long range magnetic field. For purposes of example and without limitation, one turn of a screw (206a or 206b) in certain example embodiments may translate into about a 0.8mm adjustment in height of the closest corresponding magnet segment 208. It will be appreciated that in other example embodiments, both of screws 206a-b may be used for height adjustment and/or for fixing the height.

Rollers (not shown) may be mounted, directly or indirectly, on mounting part or support 202 and are arranged to come into rotating contact with the inner wall of the rotating outer tube 14 that supports the target material to be sputtered. Thus, the rollers prevent the inner rotating wall of the target tube (see rotating target tube 14 in Fig. 1 which rotates about axis 20) from contacting or damaging the mounting part 202, tube 201, and magnets 208 and 209. In other words, the rollers may be located in such a way as to prevent or reduce damage to the magnetic elements 208 and 209 and/or the rotating outer tube 14 in case the magnetic elements become too close to the walls of the rotating outer tube 14 as a result of shimming and/or adjustments via screws 206a-b. It will be appreciated that the position of the rollers may also help avoid and/or reduce other potential mechanical influences.

Water may be fed through the magnet bar structure from one side via an inlet and out through the other side via an outlet, for cooling purposes. An example assembly may include several side inlet/outlet holes, as well as a front inlet/outlet hole for water distribution, for purposes of cooling the structure during sputtering operations. This arrangement enables the water or other coolant flow to be varied and more precisely defined, as optional steel components (not shown) may be attached to the holes to vary the sizes thereof, independently and adjustably. In certain example embodiments the inlet/outlet segments may be screwed or otherwise attached to the magnetic segments, potentially providing more opportunities for modifications and/or fine adjustments.

It will be appreciated that magnetic segments 208 are attached to magnet carrier supports and corresponding magnet carrier modules 207. Attaching magnet segments 208 to magnetic carrier modules in this way allows the height of the magnetic segments 208 to be adjusted, as noted above, thus increasing and/or decreasing the magnetic field and sputter rate as desired. One conventional magnet bar tuning method involved the addition of small plates (shims) under a magnet bar extending the length of the target. As noted above, in certain embodiments, a technique for tuning magnet segment 208 positions involves adjustment of one or more screws of the like.

A dual C-MAG sputtering apparatus may be similar to that shown and described in connection with Figs. 1-2, except that two target tubes 14 may be provided in close relative proximity to one another. As alluded to above, two independently operated power supplies 28 may be used in connection with a dual C-MAG apparatus for co-sputtering. The respective magnets 208 and 209 of the two target tubes 14 of the dual C-MAG sputtering apparatus may be turned away from each other to make the sputtered distribution more uniform or turned toward each other to allow the deposition profile to be focused over a smaller area.

As noted above, there is a need in the art for improved techniques for depositing TCO films. Whereas typical metallic targets suffer from the above-described and/or other drawbacks, certain example embodiments described herein make use of a special characteristic of the C-MAG targets. Namely, the moving target surface relative to the eroding plasma of C-MAG target surprisingly and unexpectedly allows a dynamic balance between target surface oxidation and oxide removal to be established. Thus, the combination of the example process conditions described herein with a closed-loop control of the erosion/oxidation process based on an oxygen sensor surprisingly and unexpectedly leads to a very stable and controllable process, even for large cathodes as used in industrial glass coaters which, in turn, leads to superior coating techniques in terms of deposition rate and quality as described below.

In general, the examples described herein were performed on a glass coater having a standard dual C-MAG equipped with a metallic IT (90-95% indium, 5-10% tin alloy) installed. The coat zone also was equipped with a Zirox type oxygen partial pressure sensor, which may be used in a closed-loop control system (acting on the oxygen flow, the cathode power, or a combination of the two) to maintain a substantially constant oxygen partial pressure.

A manual operation of the installed targets resulted either in transparent nonconducting films or strongly absorbing conductive films. The process range, where transparent and conductive films can be obtained, was not accessible because of the tendency to slip into the metal/oxide transition range. Such difficulties are typical for reactive sputtering processes.

However, a closed-loop control system based on an oxygen partial pressure sensor was installed and tested to attempt to alleviate these problems. Using normal process conditions, especially gas flow distributions and pressure regions as in other reactive processes like tin oxide (e.g., SnO₂ or other suitable stoichiometry) and zinc oxide (e.g., ZnO or other suitable stoichiometry), the control loop resulted in certain improvements as a semitransparent film (20-30% Tvis) with some conductivity could be achieved. However, even with the closed-loop control, it still was not possible to stabilize the process enough to obtain a uniform, low absorbing and conductive film.

The inventors of the instant application discovered that certain deviations from standard process conditions, together with the inclusion of a closed-loop control system based on an oxygen partial pressure sensor, ultimately could obtain a stable process for transparent conductive film deposition.

First, a substantial amount of the total oxygen flow was added on the top gas inlet, which is located behind the C-MAG tubes and thus far away from the substrate. Preferably, at least about 65% (more preferably at least about 75%, and still more preferably about 90%) of the total oxygen flow will be added on the top gas inlet. Adding oxygen close to the substrate as it is common for planar targets (e.g., when depositing NiCrOx coatings) using aperture shields to separate film oxidation from target oxidation led to increased instability and even lower transmitting films. Surprisingly and unexpectedly, it is preferable to oxidize the target surface and sputter from the thin oxide layer at the target surface in a similar way as when using a "full body" ceramic type target. As the target is rotating a balance between oxide growth and removal by the sputtering process can be achieved.

Second, the total pressure of the discharge was significantly increased by increasing the Ar flow. Ar flow typically is about 250-300 sccm, which typically translates to a pressure of between 1-5x10⁻³ mbar. In contrast, certain example embodiments increase the Ar flow at least by a factor of two, and preferably to about 600 sccm (more preferably about 700 sccm, and still more preferably 800 sccm), to obtain a situation were substantial uniformity across the width of the coater could be tuned by using the tuning gas segments. As above, it is preferable to add the majority of the Ar flow to the volume surrounding the target tubes, e.g., via a top gas inlet.

Third, reducing the tube rotation from the typical 20 RPM as low as possible, less than e.g., preferably to less than about 5 RPM (more preferably at about 4 RPM, and still more preferably at about 3 RPM), improved fluctuation of film composition with time which, in turn, substantially reduced (and sometimes even eliminated) the presence of periodic absorption bands across the coater width on the glass substrate. The bands seemed to be caused by oscillations generated by the rotation of the target tubes. Thus, reducing the tube rotation to half-speed, more preferably one-quarter speed, helps obviate this problem, as the target erosion or oxidation apparently is not completely uniform along the target outside diameter.

Fourth, because of the lower rotation speed, the remaining oscillation became clearly visible as oxygen partial pressure variations on the Zirox sensor. Thus, it is possible to reduce (and sometimes even eliminate) the remaining oscillation by using a finely tuned closed-loop control in which power adjustments are made to compensate for the oxygen partial pressure variations. In other words, the power may be increased or decreased in dependence on the presence or absence of oscillations.

The measures discussed above led finally to a transparent (e.g., less than 3% absorption) and conductive (e.g., 100-200 ohms/sqr for a 100 nm film). The obtained sheet resistance and thickness uniformity are described in the first example below, although it will be appreciated that further optimization of these and/or other film properties is still possible.

For example, thickness and resistance uniformity across the width of the coater can be obtained by increasing total pressure, e.g., in Ar flow about 600 sccm. Additionally, as the center part of the glass shows the thickest films, pressure distribution across the width caused by the center location of the turbo pump may have a resultant impact on the film. Because oxygen (and Ar) preferably is pumped away in the center part close to the pump, less target oxidation and thus thicker films may be produced. To balance pump speed in the center with the end sections, screens may be installed in the pump slits along the cathode in certain example embodiments. The increased pressure may help to reduce pressure differences caused by the pumps, provided that the impact is large enough to at least partially compensate for the effects introduced by the pump. A further reduction of rotation speed may enhance process controllability yet further and, thus, advantageously affect the operating window. For example, it is possible to reduce rotation speeds down to 1-2 RPM.

The optimization of these process conditions and the application of the deposition method may not just lead to advances in the deposition of TCO films on large scale glass coaters like ITO, ZnAlOx and SnSbOx, but also may open up also new possibilities for other architectural applications. In particular, the C-MAG process for depositing slightly sub-stoichiometric NiCrOx may be optimized in a similar way. Film properties usually obtainable only with ceramic-type targets may become also accessible with metallic targets (e.g., ZnO growth layers). As stoichiometric films are typically denser than the over oxidized films used in most architectural coatings because of current process restrictions, improvements in thermal and chemical stability for heat treatable stacks may result when using better stoichiometry control for critical layers.

### EXAMPLE

Lambda sensors/controllers were integrated into dual C-MAG sputtering apparatuses in certain example embodiments, which involved making hardware and software modifications for two test coating zones. As alluded to above, one or both of the coat zones of certain example embodiments may be configured to perform closed-loop control of power, gas flow, and/or the combination of power and gas flow, e.g., during the deposition of metal oxides, in conjunction with the Lambda sensor/controller. For example, a first coat zone may be used to deposit ITO using both power and combination of power and gas flow control modes, whereas a second coat zone may be used to deposit ZnAlOx using the power control mode.

Various ITO process parameters were developed for use in the first coat zone in certain example embodiments. It was possible to achieve an ITO coating using 25kW power, 1m/min line speed, and 600 sccm Ar flow. The ITO was about 100nm thick and had a cross ribbon absorption loss no more than 3% in the visible spectrum. Sheet resistance was less than 200 ohm/square. A Lambda sensor was used to provide closed-loop control in either the power or the combination of power and gas flow mode. Further optimizations to improve thickness uniformity are described below.

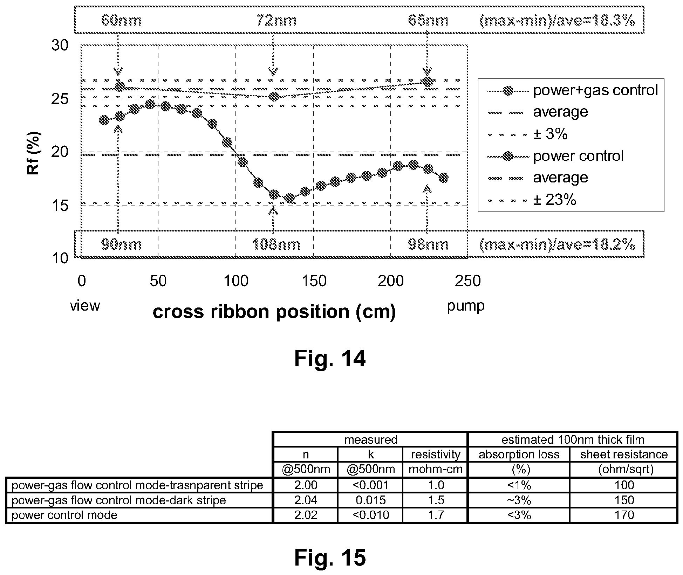

Under the combination of power and gas flow control mode, 70nm ITO thin films with cross-ribbon sheet resistance less than 200 ohm/square and absorption loss less than 1% were fabricated. The center of the film was about 9% thicker than the two sides, as shown in Fig. 14. At 1m/min line speed, 3 bands were observed on test lites. The banding is mainly caused by absorption difference, not thickness. As described in greater detail below, with increased pressure, the banding becomes less significant. The process of 600 Ar flow is preferred to the 400 one, and further increases are yet more preferable. Reduced target rotation speed also improves the difference among bands. Therefore, 5 RPM was used during process development, instead of 20 RPM, and further reductions are yet more preferable.

Under the power control mode, 100nm thick ITO with cross-ribbon sheet resistive less than 200 ohm/suare and absorption loss less than 3% were fabricated. With the trade-off of absorption loss and conductivity, the banding is eliminated. However, cross-ribbon Rf variation as high as 23% was observed as shown in Figure 14. Further analysis shows that the thickness uniformity is less than desirable as those fabricated at the combination of power and gas flow control mode. The less than desirable uniformity may be mainly caused by a higher pumping rate at the center than two ends. However, as discussed in greater detail below, increasing Ar flow further and/or blinding the center pump improves the uniformity. Slowing down the target rotation also improves the process window to achieve the reduced absorption loss. Replacing a fixed magnetic bar with an adjustable one also improves uniformity.

Low conductivity ZnAlOx using the Lambda sensor controller in the power control mode also was verified in the second coat zone.

Fig. 14 shows the cross-ribbon thickness variation of ITO thin films fabricated under the control of the Lambda sensor controller at two different modes in accordance with the example process conditions described in this section. Fig. 15 includes properties of ITO thin films fabricated under different control modes. In particular, Fig. 14 shows cross-ribbon Rf and thickness of ITO deposited at Ar flow rate of 600 sccm under different Lambda sensor control modes. With the power control mode, the lambda sensor setup was at 273.3mV and total 02 flow was 486.8ml. With the combination of power and gas flow control modes, the Lambda sensor setup was at 277mV. Both modes had the power supply running around 25kW during ITO deposition.

Advantageously, no damage or degradation to the InSn targets was observed after 600kW-hr usage. The max power and pressure the InSn rotary targets experienced were no more than 27kW and 7 mhPa, respectively.

### EXAMPLE OPTIMIZATION OF SINGLE LAYER ITO DEPOSITION PROCESS

Described below are the results of one example ITO optimization process. In brief, it was possible to obtain ITO films with a resistivity around 1 mOhm-cm with absorption levels at 3-5%. Using trim oxygen gas to balance thickness uniformity resulted in a systematic thickness peak in the center of the lite. This peak was about 7-10% higher than the outlying areas and was accompanied by an increase in absorption, indicating a deficit of oxygen in the center area. Further improvements may be possible when using a more dedicated way to adjust the trim gas, as discussed in greater detail below. It will be appreciated that the coating's surface thickness preferably varies less than about 10%, more preferably less than about 7%, still more preferably less than about 5%.

Absorption across the sheet (e.g., 100- Y_{T} -Y_{RF}) turns out to be a parameter closely correlated with thickness variations and thus may be used as a quick guide to adjust uniformity. Target values are in the range of about 3%-4%. At 2%, the sheet resistance typically runs away to high numbers very quickly, indicating an over-oxidization. Sheet resistance / specific resistivity showed a minimum for absorption levels around 10%. It rises sharply below 2.5% and with a much weaker dependence towards higher absorption levels.

Adjustments in Lambda settings (composition) toward less absorbing films enhance small variations in thickness / composition uniformity. Thus, low absorbing films are the most sensitive to uniformity variations.

Rather than adjusting and viewing trim settings as percentage of the total trim flow or as absolute sccm values, it is also possible to look at the relative deviation from a flat gas distribution. Using the former approach, it is sometimes difficult to "fine tune" the uniformity without using a "trial and error" approach. Using the latter approach, the correlation between thickness / absorption variations and settings is more comprehensible and thus easier to control, especially when using a graphical display.

Banding or thickness/absorption variations in transport direction were observed only on relatively high absorbing layers (e.g., absorption > 20%). For the more transparent layers, there was no visible banding following control loop optimization.

Using the "power mode" for the Lambda controller was advantageous, as the operation take place within a range where relatively quick variations happen and flow control would have been too slow to balance out periodic process fluctuations possibly related to target rotation.

Lowering target rotation speed to 3 RPM improved stability yet further, whereas increasing the rotation speed temporarily to 12 RPM resulted in an immediate flip of the cathode into oxide mode without being able to stabilize the cathode on the same operating point.

Pressure was increased to about 8.7 hPa by increasing Ar flow to 800 sccm. The increase from 600 sccm to 800 sccm further improved uniformity of sheet resistance and increased obtainable thickness by about 10% under similar power levels. Surprisingly and unexpectedly, the transition range from metallic-to-oxidic shifted to lower oxygen flow levels for the higher Ar flow, which indicates that the higher pressure enhances the tube oxidation despite the larger sputter yield, which behaved as expected and normally would require more reactive gas to keep the same film composition. This may be a result of feeding the gas primarily behind the tubes (top gas inlet).

### General Settings and Procedures

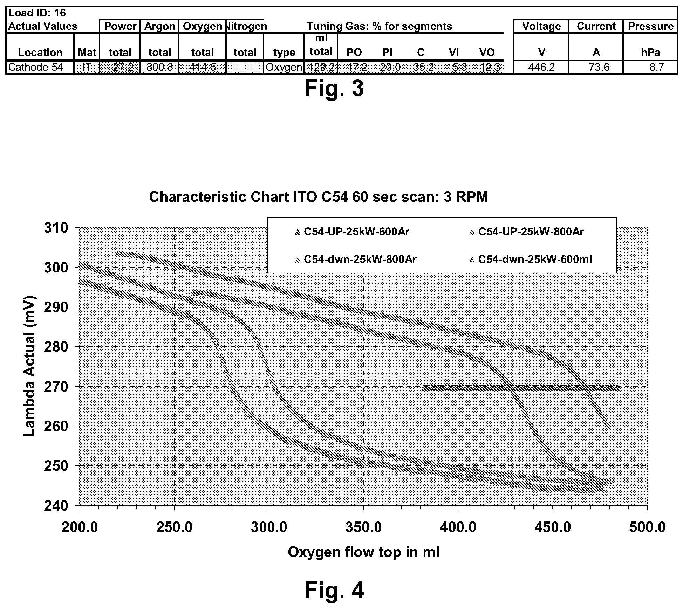

Fig. 3 shows the settings used for the single layer sample of ITO produced in accordance with an example embodiment. This sample may be used to produce full stack samples. The Lambda set point was 272 mV, and the transport speed was 1m/min. The Ar gas was split 80% to the top gas inlet and 20% to the bottom. The oxygen flow on the bottom main bars was fixed to 90 sccm, and trim oxygen, as well as the remaining total oxygen flow, was fed into the top gas inlets. The tube rotation speed was set at 3 RPM. All other samples discussed below were made with similar parameters, with the exception of variations in flow and Lambda settings specifically mentioned.

To evaluate the properties of the deposited films, 24 samples (approx. 4"x4") were cut across the substrate to evaluate cross-ribbon uniformity. These samples were measured at the Hunter UltraScan XE for T, RF and RG. Sheet resistance was measured using a contact-less Ohmmeter. Using the spectral data of the optical measurements thickness, n & k for all samples were estimated using OptiRe, set up with an appropriate model. The obtained data were used to adjust the uniformity profile and the layer composition.

### Hysteresis Loops

Hysteresis loops of oxygen flow versus oxygen partial pressure (Lambda signal) were taken for the 600 and 800 sccm Ar settings using an automated procedure in the Lambda process control unit, which allows for the ramping of gas flow and the collection of data at a predefined time rate. This, in turn, allows the dynamic behavior of the process to be estimated, thus differentiating between geometric setups such as, for example, rotation speed, location of gas feeds, etc. It will be appreciated that a hysteresis loop is only representative if uniformity across the cathode is within a reasonable range, as the measured parameters are averages for the whole cathode and may be significantly distorted when a cathode is running in an asymmetric mode. It also will be appreciated that different Ar flow rates likely will have an impact on hysteresis behavior, as will tube rotation speed and gas distribution between top and bottom gas.

Fig. 4 compares the data taken for 600 sccm Ar and 800 sccm Ar flow at otherwise constant process conditions (e.g., power and gas distribution). The top main oxygen flow was first increased from 200 sccm to 500 sccm at a constant rate of 5ml/sec and, after settling the target for a few minutes, was reversed using the same ramp speed downwards. The oxygen flow values shown in the chart are only the variable part of the oxygen. To obtain the total oxygen flow, it is necessary to add the 90 sccm fed at the bottom and the 130 sccm used in the trim segments, which were both fixed during the test.

The "UP" values are data taken when increasing the oxygen flow starting at low flow values, and these values are most appropriate for the conductive layers of certain example embodiments. The horizontal bar in the chart marks the Lambda sensor operating level required to obtain a low absorbing high conductive ITO layer. Surprisingly and unexpectedly, the operating point is inside the steep region of the transition from a metallic to an oxidic target surface coverage.

Surprisingly and unexpectedly, the oxygen flow triggering the transition is about 40 sccm lower for the case with 800 sccm Ar compared to the 600 sccm Ar case. The higher Ar flow and the resulting higher process pressure leads to a higher target erosion rate, which is indeed confirmed by the samples run for these conditions at the same set point. However, a higher (metal) target erosion rate normally would require more oxygen to obtain a comparable composition in the film. The unusual behavior observed here may be explained by a higher target surface oxidation rate during the time the target surface is outside the eroding plasma caused by the higher pressure (more collisions with oxygen). The difference in the target surface oxidation seen here is possibly enhanced by the slow rotation speed and the reactive gas fed primarily at the back side of the tubes.

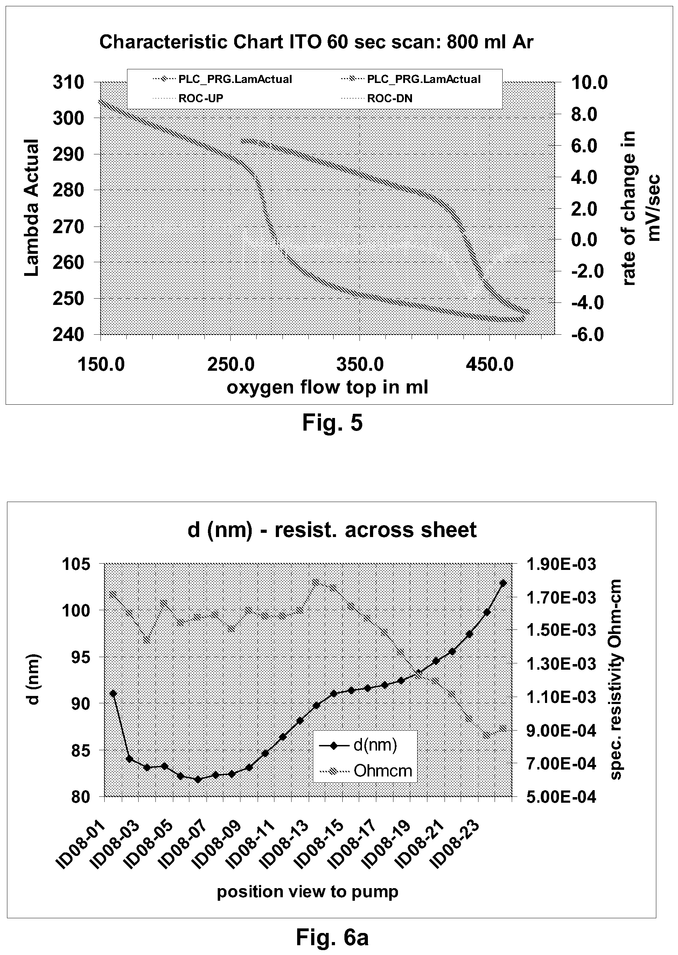

The rate of change at the typical operating point is closely related to the dynamic behavior of the process. A steep transition makes it increasingly difficult to stabilize the process using an active feedback control loop. The dynamic response times of such a large system is in the range of seconds or larger and, thus, any fluctuation or drift, which often happen much more quickly, cannot be stabilized. Fig. 5 shows the transition chart obtained for 800 sccm Ar, with the rate of change in the Lambda signal included. At the typical operating point, a rate of change of approximately -2.0 to -3.5 mV/sec is observed for the given flow rate change. The smaller in absolute terms this rate of change parameter is, the easier it is to control the process. In this case, the rate is already too big to work with a flow control loop, which has about 1-2 sec response time itself because of the volume of the gas bars and the flow controller response. To overcome this challenge, it is possible to work a power control loop.

Fig. 5 shows a considerable asymmetry in rate of change between the metal-to-oxide transition and the oxide-to-metal transition, which is much quicker and thus would be much more difficult to control. Performing this sort of analysis for different geometries of gas feed and tube rotation is useful in selecting favorable conditions for a given process requirement. In this case, it is desirable to keep the metal-to-oxide transition at the target as slow as possible, which was possibly achieved at the expense of the oxide-to-metal transition.

### Film Parameters Using Low and High Pressure Ar (600 sccm Ar vs. 800 sccm Ar)

Single layers obtained with flowing 600 sccm Ar (ID 08) and 800 sccm Ar (ID09) and otherwise identical settings at the preferred operating point are evaluated in the following charts. The process pressure changed from 7.3 x10⁻³ to 8.8x 10⁻³ mbar because of the higher Ar flow. The samples were run with 1 m/min transport speed.

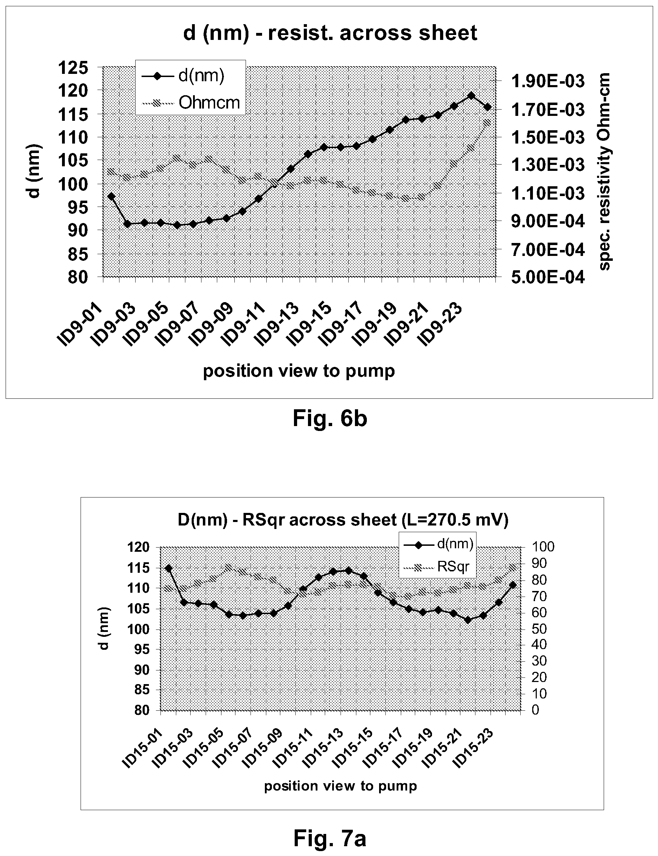

Figs. 6a and 6b show the thickness and resistivity profiles for the low and high pressure samples, respectively. The films exhibit a similar thickness profile, which was not specifically tuned. On the low pressure samples, thickness varies between about 82 to 100 nm, whereas it is between about 91 and 115 nm for the high pressure sample. Overall, this represents approximately a 10% increase in thickness due to the higher pressure. Specific resistivity was calculated from thickness and measured sheet resistance and is included in the chart. For the high pressure sample, the resistivity variation is considerably smaller and thus indicates an improvement in compositional uniformity. Given the higher deposition rate together with the better compositional uniformity, the higher Ar flow was deemed desirable (although is not required for all embodiments of this invention) and was used for the following tests.

### Impact of Lambda Setting on Uniformity

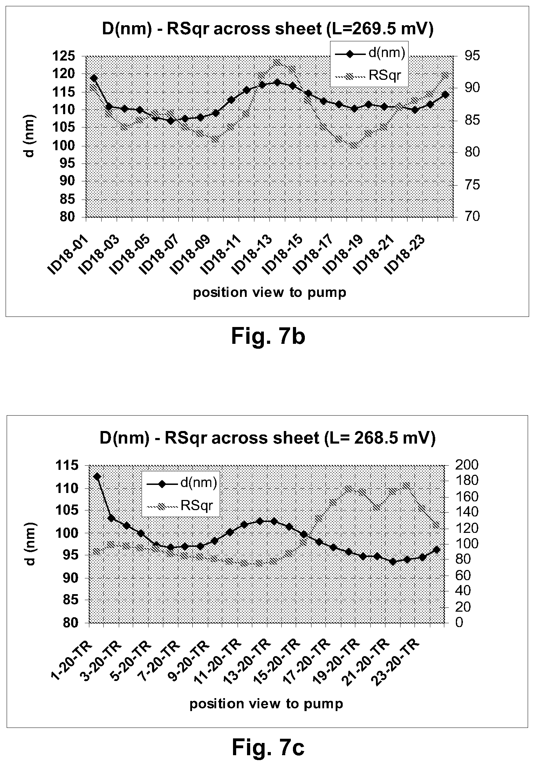

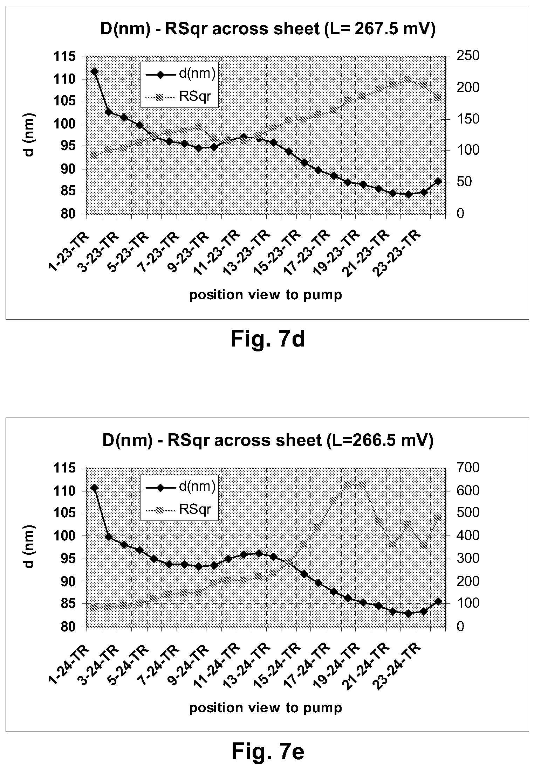

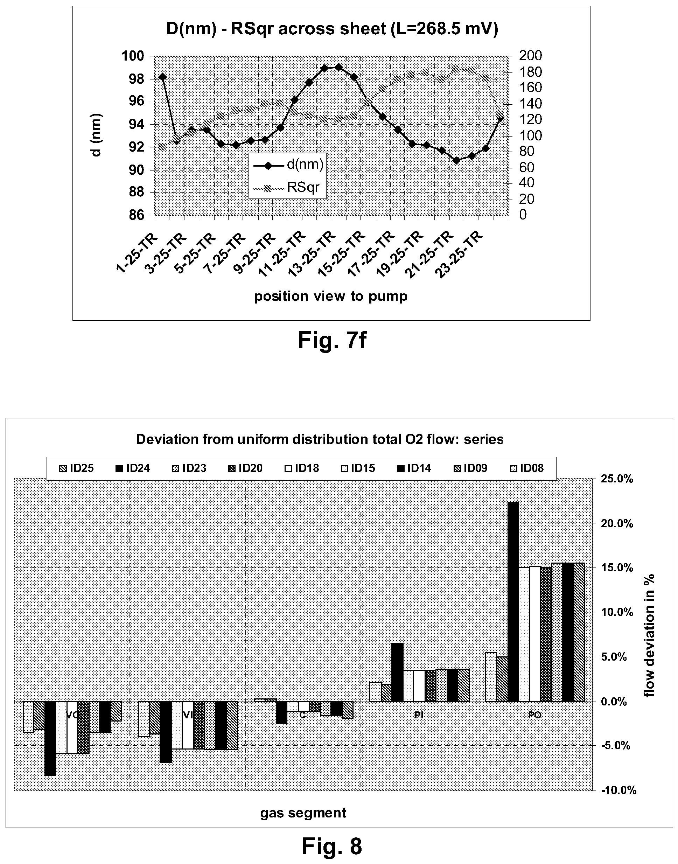

A series of samples was produced with different settings in the Lambda control set point. That is, Figs. 7a-f show a series of thickness and resistivity profiles for the varying Lambda control set points. The profile was initially tuned as finely as possible for a sample that still had about 15% absorption (ID15 shown in Fig. 7a), and the set point was then lowered in steps of 1 mV to reduce overall absorption. At the end of the series, the set point showing an absorption level of about 3-5% was chosen and re-tuned (ID25 shown in Fig. 7f).

The series shows that thickness drops and sheet resistance rises considerably faster toward the pump side with decreasing Lambda set point than for the view/center region. However, it seems that there was already a bit too much oxygen tuning gas on the pump side at the initial sample. Moving to lower absorption seems to enhance an imbalance of tuning gas and make it simply more visible.

Making an appropriate adjustment in the trim gas for sample 25 (Fig. 7f), which was run at similar settings as ID20 (Fig. 7c) restores the uniformity profile. Fig. 8 shows the deviation from uniform distribution that was returned for all samples, although it may be desirable to at least somewhat reduce the amount of oxygen at the pump side, even for the ID25 sample. The tuning gas also was moved for each of the samples, and this is shown along the x-axis in Fig. 8.

The tuning chart shows the deviation in flow percent from a flat oxygen distribution taking into account the trim and main flow and the number of nozzles per segment. The correction on ID 25 was mainly a small increase of oxygen level at the view side, which helped thickness uniformity somewhat. However, to remove the pump side peak in sheet resistance would require a reducing in the PI segment, which should also reduce the tilt in thickness uniformity toward the pump side. A more detailed discussion on uniformity tuning follows below.

### Thickness Uniformity and Absorption

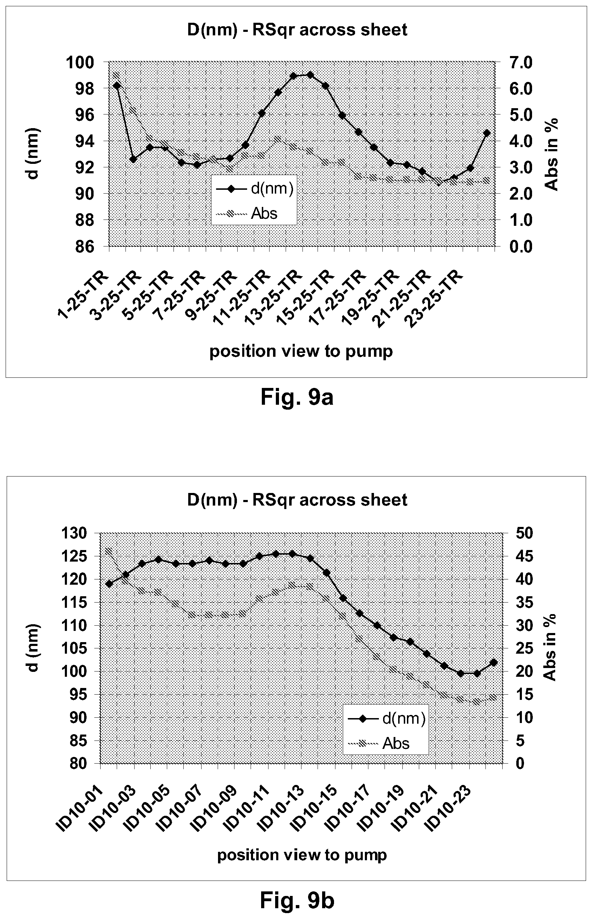

As noted above, there apparently is a good correlation between thickness uniformity and absorption calculated from 100 - Y_{T} - Y_{RF} (all data include glass absorption). This may provide a quick way to estimate deviations and make corrections without having to calculate actual thickness data. Examples are shown in Figs. 9a-b.

Fig. 9a is the ID25 sample discussed in the previous section, which seems to have slightly too much oxygen at the pump side. The absorption does not show the full details of the center peak, but clearly has a tilt toward the pump side. Also, it flattens out around 2.5%, which indicates that the film is already over oxidized in this region, which is the reason for the steep rise in sheet resistance. Fig. 9b shows sample ID10, which was an intermediate tuning sample with considerable non-uniformity and absorption. As shown in Fig. 9b, absorption follows fairly well the calculated thickness profile.

The correlation is particularly helpful for samples showing absorption levels above about 3%. Lower absorption levels indicate an over-oxidized situation and therefore no longer contain thickness related information. However, for the current type of films, which should be conductive, this is not a constraint, as a small amount of absorption is useful for keeping the sheet resistance low.

### Tuning Gas Flow Visualization

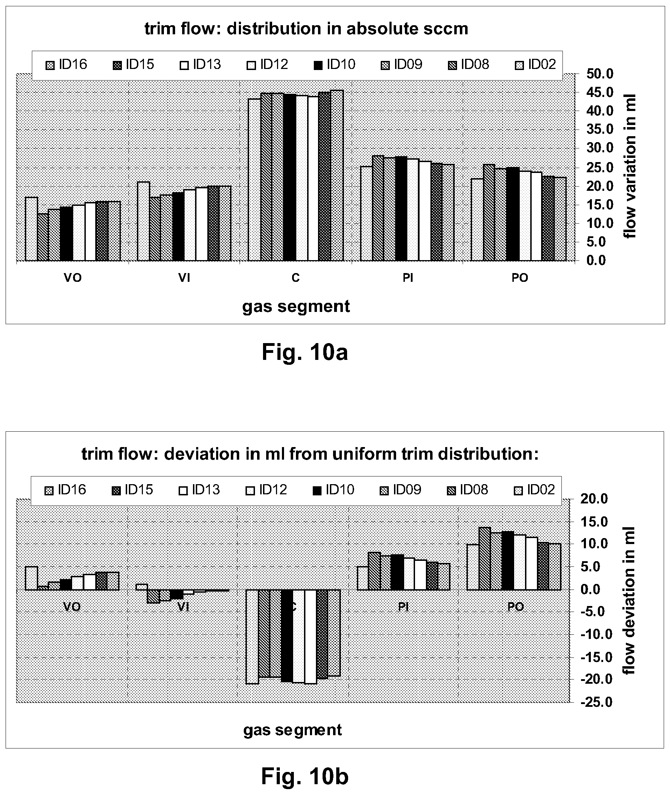

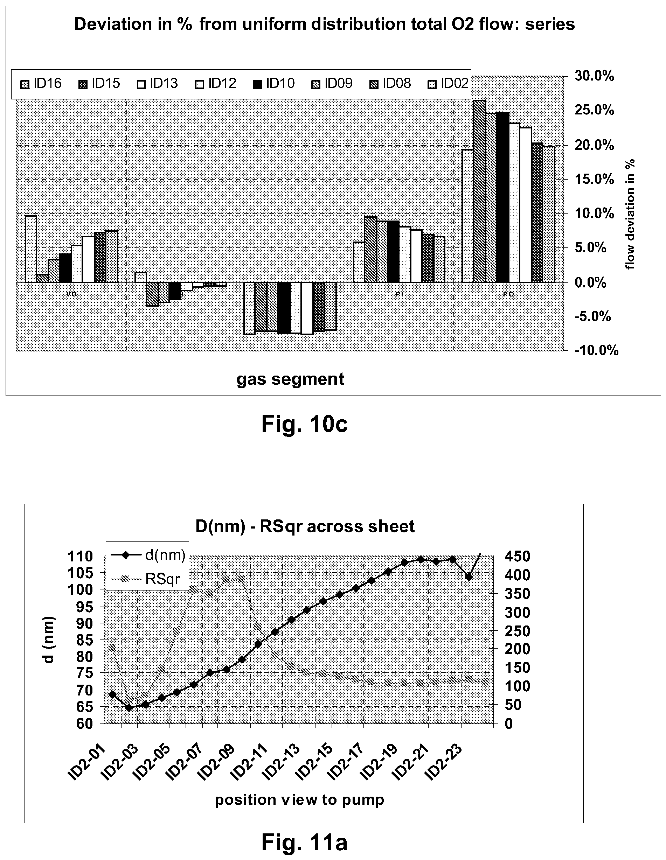

Figs. 10a-c represent different ways to visualize the trim gas flows used during the tuning of the single layers. These visualizations are illustrative. ID16 refers to the final setting which could be used for the production of full stack samples. Fig. 10a plots the flow values as entered and displayed on the console. Fig. 10b plots the difference between the actual flow values and the ideal flat distribution for the given amount of tuning gas. This simply takes into account the number of nozzles for the different segments. Fig. 10c finally plots the relative deviation of flow values in percent compared to a flat gas feed situation taking into account the total oxygen gas flow (including main flow).

Comparing the flow to an ideal flat distribution makes it easier to visualize the impact on the final thickness distribution profile. The technique using the relative deviation for the entire oxygen flow is most likely the most "universal" approach, as it covers situations for different power levels and different overall trim flow settings, which otherwise completely change the overall situation. Thus, in certain example embodiments, a user interface may be configured to enable a user to adjust and display trim settings as relative deviations from a flat gas distribution.

### Uniformity Adjustment

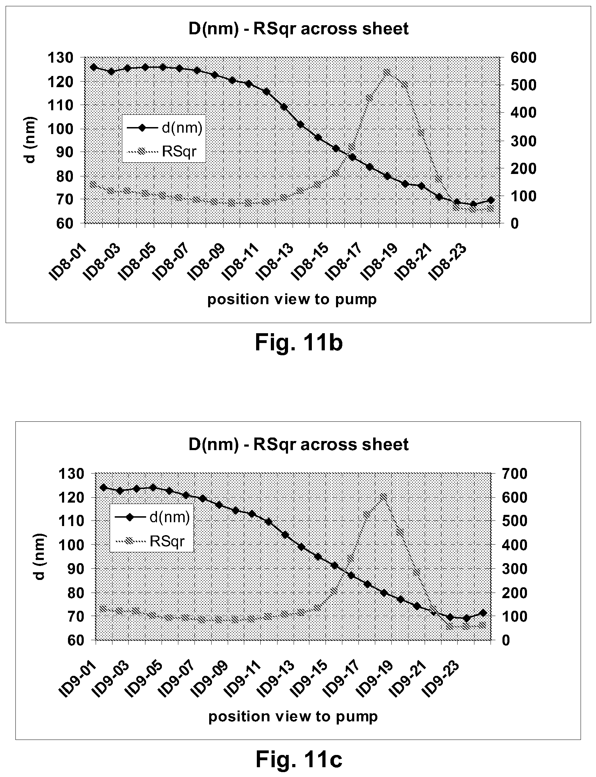

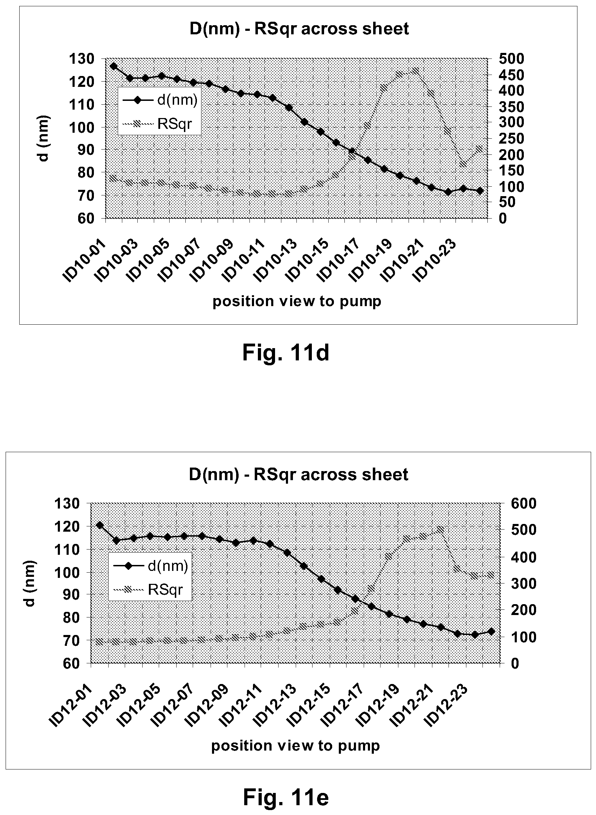

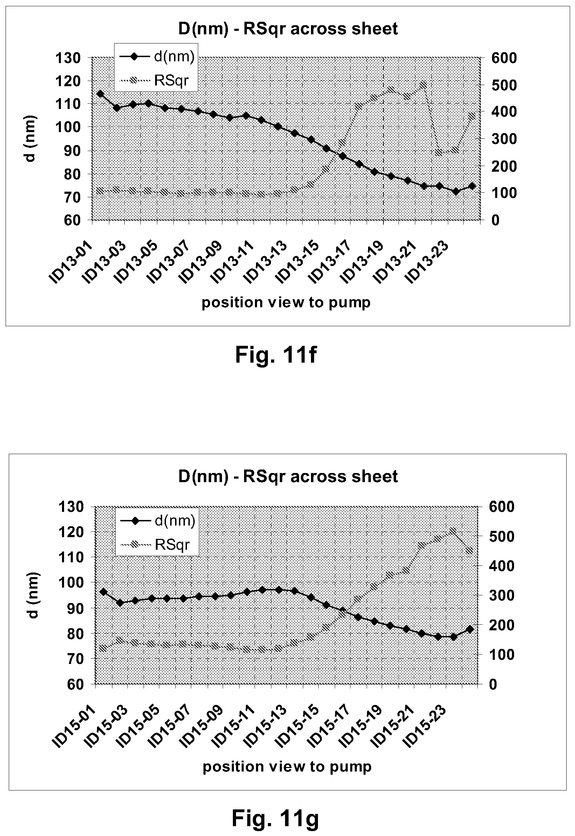

Figs. 11a-h summarize the moves in trim gas settings to obtain a reasonably flat thickness and resistance profile. The figures and the analysis provide hints as to the sensitivity of trim gas moves. They also show that, in essence, the final trim profiles seen as the best look surprisingly similar when viewed under appropriate scaling. This means that the uniformity profile is primarily a pattern defined by the cathode bay (pumps) or the target / magnetbars, and not a random variation. Even as the uniformity may be limited for the current setup by factors that may not be changed by the trim gas settings, there is a good chance to obtain further improvements by working on the geometry of the deposition bay / cathode.

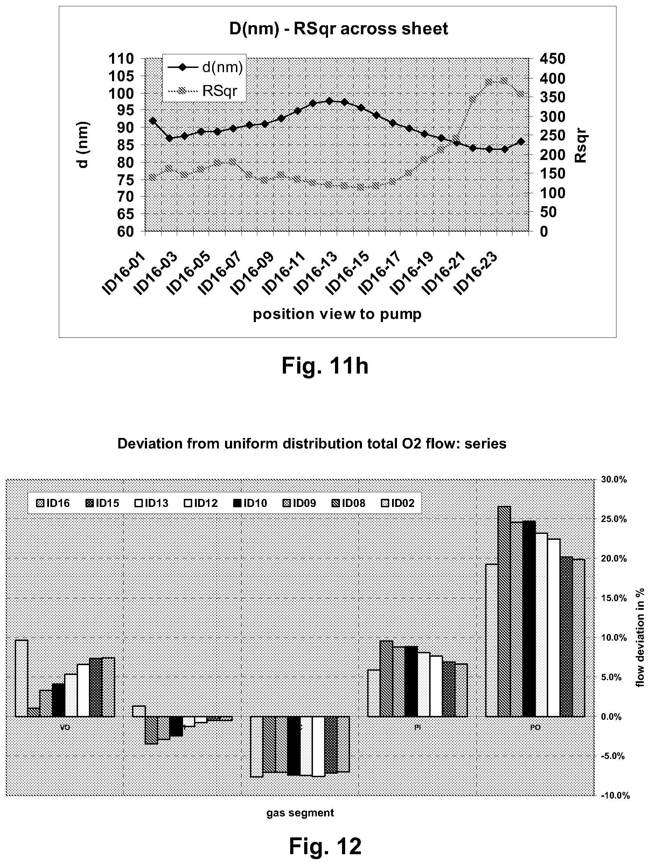

Fig. 11a shows the starting point for the tuning. The trim gas move performed before second sample was too much and flipped the thickness profile completely. From there, gradual moves were taken to flatten the thickness distribution. The final settings on ID16 (in Fig. 11h) look reasonably flat for thickness uniformity despite the characteristic peak in the center. However, based on resistance and the small tilt in thickness toward the pump side there still may be too much oxygen flowing at the pump side segments.

Fig. 12 summarizes the trim gas moves discussed above and shows the relative deviation of oxygen flow from a flat distribution. Based on Fig. 12, it appears that only a minor adjustment was required to get to ID16 from to the starting set of ID02. The problem was rather the overshooting in the second step and the gradual reversal of that setting.

If the final trim settings for ID25 above that yielded a clearly better profile is compared with the ID16 here, it appears that moving further toward the final ID25 settings would have given further improvements, in particular, shifting oxygen from the PI section to the VI section.

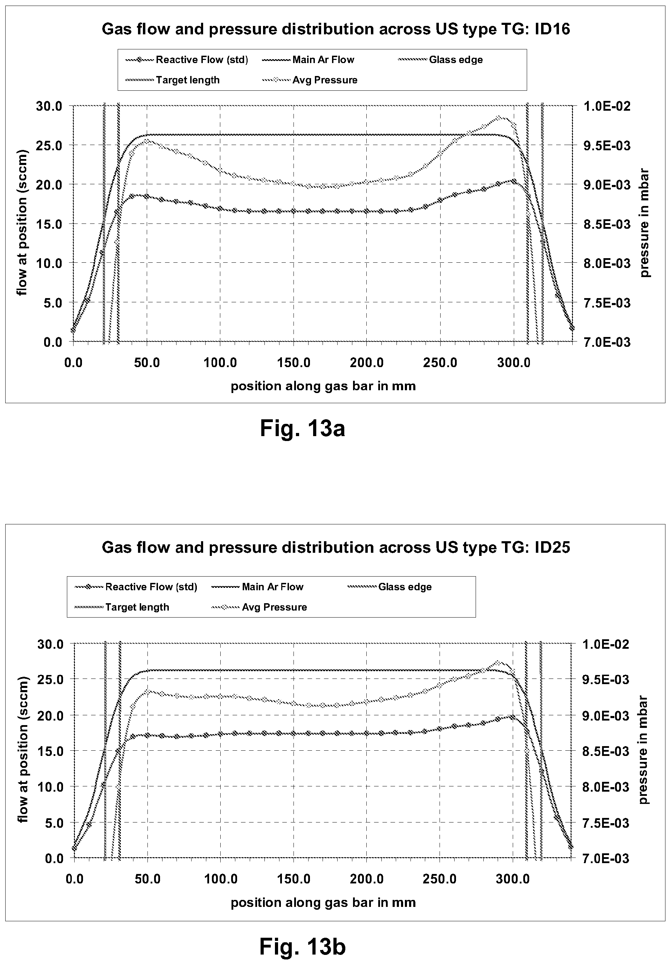

The overall pressure variation across the coat bay was calculated for the best two settings ID16 (see Figs. 12 and 13a) and ID25 (see Figs. 8 and 13b) taking into account pump speed variation and gas flow distribution as set. The calculated pressure profile matches fairly well with the inverted thickness profiles. In both cases, the overall pressure is significantly lower in the center compared to the edges given the current trim gas settings. There likely are settings that could avoid this pressure drop. However, changing these setting may affect the compositional uniformity. Thus, other approaches for the trim gas to target a flat "pressure" profile may be possible. Still further, changes may be made on the hardware to reduce the required asymmetry of the gas settings.

One possible hardware modification involves shimming the pump slits around the center Turbo. Another possible modification involves the use of adjustable magnet bars to reduce of the sputter rate in the center. One risk associated with magnet bar tuning, however, is that the required settings may be inverse to the settings required when running films in oxidic mode in the standard setting. In oxide mode (e.g., for SnO₂, ZnO, etc., production) the thickness profile typically is at its low point in the center. This is most likely caused by the fact that Ar pressure variations dominate the erosion rate, and low pressure at the center is observed because of the location of the pumps. For a process run on the metallic side the reactive gas (oxygen) dominates the rate but, here, low oxygen pressure increases the rate so a reversal may be expected. Therefore, if the non-uniformity is pressure driven, only pump port adjustments would lead to an improvement for both scenarios.

Although certain example embodiments have been described herein as using Ar, it will be appreciated that other inert gasses may be used in place of or in addition to Ar.

Flow values tend to be equipment-specific terms, as they tend to depend on cathode and chamber size, pump speed, and/or the like. Thus, the pressure ranges appropriate for certain example embodiments, expressed in an equipment-independent manner, correspond to about 10⁻³ to 10⁻² mbar (or even higher), with greater detail shown in Figs. 13a and 13b for the example embodiments described herein. A more preferable pressure range is about 5x10⁻³ to 10⁻² mbar (or even higher), and a yet more preferable pressure range is about 7x10⁻³ to 10⁻² mbar (or even higher).

While a particular layer or coating may be said to be "on" or "supported by" a surface or another coating (directly or indirectly), other layer(s) and/or coatings may be provided therebetween. Thus, for example, a coating may be considered "on" and "supported by" a surface even if other layer(s) are provided between layer(s) and the substrate. Moreover, certain layers or coatings may be removed in certain embodiments, while others may be added in other embodiments of this invention without departing from the overall spirit of certain embodiments of this invention. Thus, by way of example, an encapsulating coating applied in liquid sol-gel form in accordance with an example embodiment may be said to be "on" or "supported by" a sputtering target material, even though other coatings and/or layers may be provided between the sol-gel formed coating and the target material.

While the invention has been described in connection with what is presently considered to be the most practical and preferred embodiment, it is to be understood that the invention is not to be limited to the disclosed embodiment, but on the contrary, is intended to cover various modifications and equivalent arrangements included within the scope of the appended claims.

## Claims

1. A method of making a coated article, the method comprising:
providing an article to be coated;
providing a sputtering apparatus comprising:
a vacuum chamber,
first and second rotatable cylindrical tubes located in close relative proximity to one another in the vacuum chamber, the first and second tubes respectively supporting first and second sputter targets including target material,
at least one power source operably connected to the first and second sputtering tubes, and
a top gas inlet located proximate to the first and second tubes and on a side of the tubes opposite the article to be coated;
providing an oxygen flow to the vacuum chamber through the top gas inlet;
providing an inert gas flow to the vacuum chamber to increase pressure therein to about 10⁻³ to 10⁻² mbar;
rotating the first and second tubes at less than about 5 RPM;
detecting the oxygen flow within the vacuum chamber and/or an amount of power applied to the first and second tubes;
detecting oxygen partial pressure;
adjusting the oxygen flow and/or amount of power provided by the at least one power source to compensate for any detected oxygen partial pressure variations; and
depositing a coating on the article to be coated in making the coated article.

2. The method of claim 1, wherein the inert gas is Ar.

3. The method of claim 2, further comprising:
rotating the first and second tubes at less than about 3 RPM;
providing the inert gas flow to the vacuum chamber at at least about 800 sccm.

4. The method of claim 3, further comprising providing a trim oxygen gas flow to the vacuum chamber via at least one second gas inlet.

5. The method of claim 4, further comprising displaying and adjusting trim settings as relative deviations from a flat gas distribution, wherein about 90% of the oxygen flow is provided via the top gas inlet, and
wherein the trim oxygen gas flow is provided to aid in coating thickness uniformity.

6. The method of claim 4, wherein the first and second sputter targets are indium and tin-alloy targets.

7. The method of claim 4, wherein the coating is a transparent conductive oxide coating, preferably selected from the group consisting of: ITO, ZnAlOx, SnSbOx.

## Patentansprüche

1. Ein Verfahren zum Herstellen eines beschichteten Gegenstands, das Verfahren aufweisend:
Bereitstellen eines zu beschichtenden Gegenstands;
Bereitstellen einer Sputter-Vorrichtung aufweisend:
eine Vakuumkammer,
eine erste und zweite drehbare zylindrische Röhren, welche in unmittelbarer relativer Nähe zueinander in der Vakuumkammer angeordnet sind, wobei die erste und zweite Röhre ein erstes bzw. zweites Sputter-Target, beinhaltend Targetmaterial, stützt,
zumindest eine Stromquelle, welche betriebsfähig mit der ersten und zweiten Sputter-Röhre verbunden ist, und
einen oberen Gaseinlass, welcher in der Nähe der ersten und zweiten Röhren und an einer Seite der Röhren angeordnet ist, welche dem zu beschichtenden Gegenstand gegenüberliegt;
Bereitstellen eines Sauerstoffflusses in die Vakuumkammer durch den oberen Gaseinlass;
Bereitstellen eines Inertgasflusses in die Vakuumkammer, um den Druck darin auf ungefähr 10⁻³ bis 10⁻² mbar zu erhöhen;
Drehen der ersten und zweiten Röhren mit weniger als ungefähr 5 RPM;
Ermitteln des Sauerstoffflusses in die Vakuumkammer und/oder einer Strommenge, die an den ersten und zweiten Röhren bereitgestellt wird;
Ermitteln eines Sauerstoffpartialdrucks;
Anpassen des Sauerstoffflusses und/oder der Strommenge, welche durch die zumindest eine Stromquelle bereitgestellt wird, um jedwede gemessenen Veränderungen des Sauerstoffpartialdrucks auszugleichen; und
Auftragen einer Beschichtung auf dem zu beschichtenden Gegenstand, um den beschichteten Gegenstand herzustellen.

2. Verfahren nach Anspruch 1, wobei das Inertgas Ar ist.

3. Verfahren nach Anspruch 2, weiter aufweisend:
Drehen der ersten und zweiten Röhren bei weniger als ungefähr 3 RPM;
Bereitstellen des Inertgasflusses in die Vakuumkammer bei zumindest ungefähr 800 sccm.

4. Verfahren nach Anspruch 3, weiter aufweisend: Bereitstellen eines Trimm-Sauerstoffgasflusses (trim oxygen gas flow) in die Vakuumkammer über zumindest einen zweiten Gaseinlass.

5. Verfahren nach Anspruch 4, weiter aufweisend: Anzeigen und Einstellen von Trimm-Einstellungen als relative Abweichungen von einer gleichmäßigen Gasverteilung, wobei ungefähr 90% des Sauerstoffflusses über den oberen Gaseinlass bereitgestellt werden und
wobei der Trimm-Sauerstoffgasfluss bereitgestellt wird, um eine einheitliche Dicke der Beschichtung zu fördern.

6. Verfahren nach Anspruch 4, wobei die ersten und zweiten Sputter-Targets Indium- und Zinnlegierungstargets sind.

7. Verfahren nach Anspruch 4, wobei die Beschichtung eine transparente leitfähige Oxidbeschichtung ist, welche vorzugsweise ausgewählt ist aus der Gruppe bestehend aus ITO, ZnAlOx, SnSbOx.

## Revendications

1. Procédé de fabrication d'un article revêtu, le procédé comprenant :
la fourniture d'un article à revêtir ;
la fourniture d'un appareil de pulvérisation cathodique, comprenant :
une chambre à vide,
un premier et un deuxième tube cylindriques rotatifs, situés à proximité relative étroite l'un à l'autre dans la chambre à vide, le premier et le deuxième tube supportant respectivement une première et une deuxième cible de pulvérisation cathodique comprenant un matériau cible,
au moins une source d'alimentation électrique, connectée d'une manière opérationnelle au premier et au deuxième tube de pulvérisation cathodique, et
un orifice d'entrée de gaz de tête, situé au voisinage du premier et du deuxième tube et sur un côté des tubes opposé à l'article à revêtir ;
la fourniture d'un flux d'oxygène à la chambre à vide, passant par l'orifice d'entrée du gaz de tête ;
la fourniture d'un flux de gaz inerte à la chambre à vide pour y augmenter la pression à environ 10⁻³ à 10⁻² mbar ;
la mise en rotation du premier et du deuxième tube à moins d'environ 5 tr/min ;
la détection du flux d'oxygène à l'intérieur de la chambre à vide et/ou d'une quantité d'électricité appliquée au premier et au deuxième tube ;
la détection de la pression partielle d'oxygène ;
l'ajustement du flux d'oxygène et/ou de la quantité d'électricité fournie par l'au moins une source d'alimentation électrique, pour compenser toutes variations détectées de la pression partielle d'oxygène ; et
le dépôt d'un revêtement sur l'article à revêtir lors de la fabrication de l'article revêtu.

2. Procédé selon la revendication 1, dans lequel le gaz inerte est l'Ar.

3. Procédé selon la revendication 2, comprenant en outre :
la mise en rotation du premier et du deuxième tube à moins d'environ 3 tr/min ;
la fourniture du flux de gaz inerte à la chambre à vide, à au moins environ 800 Ncm³/min.

4. Procédé selon la revendication 3, comprenant en outre la fourniture d'un flux d'oxygène gazeux de compensation à la chambre à vide, passant par l'au moins un deuxième orifice d'entrée du gaz.

5. Procédé selon la revendication 4, comprenant en outre l'affichage et l'ajustement des réglages de compensation, en tant qu'écarts relatifs par rapport à une distribution uniforme du gaz, au moins 90 % du flux d'oxygène étant fournis par l'intermédiaire de l'orifice d'entrée du gaz de tête, et
le flux d'oxygène gazeux de compensation étant fourni pour aider à l'uniformité de l'épaisseur du revêtement.

6. Procédé selon la revendication 4, dans lequel la première et la deuxième cible de pulvérisation cathodique sont des cibles en un alliage d'indium et d'étain.

7. Procédé selon la revendication 4, dans lequel le revêtement est un revêtement d'oxyde conducteur transparent, choisi de préférence dans le groupe consistant en ITO, ZnAlOx et SnSbOx.
